# EUROPEAN PATENT APPLICATION

(11) **EP 4 376 048 A1**
(43) Date of publication of application: **29.05.2024**
(21) Application number: 22209068.0
(22) Date of filing: 23.11.2022
(51) Int. Cl.: H01J 37/18, H01J 37/04, H01J 37/26

(54) **CHARGED PARTICLE OPTICAL DEVICE, ASSESSMENT APPARATUS, METHOD OF ASSESSING A SAMPLE**

(71) Applicant: ASML Netherlands B.V., 5500 AH Veldhoven (NL)
(72) Inventor: URBANUS, Willem, Henk, 5500 AH Veldhoven (NL); DE LANGEN, Johannes, Cornelis, Jacobus, 5500 AH Veldhoven (NL); WIELAND, Marco, Jan-Jaco, 5500 AH Veldhoven (NL); DEL TIN, Laura, 5500 AH Veldhoven (NL); KONING, Johan, Joost, 5500 AH Veldhoven (NL)
(74) Representative: ASML Netherlands B.V.

(57) **Abstract**

The present disclosure relates to charged particle devices for projecting charged particles towards a sample and methods of assessing a sample using charged particles. A charged particle optical element directs beams of charged particles towards a sample. The charged particle optical element comprising a plate in which is defined beam apertures and a plurality of vent apertures. A beam tube defines an inner tube volume comprising paths up-beam of the plate of charged particles of the beams, and an outer tube region that is outside of the beam tube. The beam apertures are for passage towards the sample of charged particles of the beams, from the inner tube volume to a down-beam volume on an opposite side of the plate to the inner tube volume. Vent apertures fluidically connect the down-beam volume to the outer tube region.

## Description

### FIELD

The present disclosure relates to methods and apparatus for assessing a sample using charged particles.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment for example inspection and/or measurement of a surface of a substrate, or other object/material, is an important process during and/or after its manufacture.

Assessment tools, which herein are referred to as assessment systems, are known that use a charged particle beam to assess objects, which may be referred to as samples, for example to detect pattern defects. These systems typically use electron microscopy techniques, such as a scanning electron microscope (SEM). In a SEM, a primary electron beam of electrons at a relatively high energy is targeted with a final deceleration step to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection system may obtain an image representing characteristics of the material structure of the surface of the sample.

In an assessment system that uses charged particles, such as an SEM, it is desirable to maintain an ultrahigh vacuum (very low pressure, for example 10⁻⁹ mbar or lower pressure) at the charged particle source. At the same time, it is necessary to provide charged particle optical elements (e.g., electron-optical elements) between the source and a sample to project the charged particles onto the sample. At least some of the charged particle optical elements may need to be located relatively close to the sample, where high rates of outgassing and/or charged particle stimulated desorption processes may limit the level of vacuum that is practically achievable, leading to higher pressures (e.g., high vacuum, which may be a pressure in the range of 10⁻⁶ to 10⁻⁸ mbar for example, rather than ultrahigh vacuum). It is desirable to minimize flow of gas through the charged particle optical elements from the region near the sample (e.g., a high vacuum region) to the source (e.g., an ultrahigh vacuum region). One approach to suppressing the flow of gas is to reduce the flow conductance (i.e., increase the flow resistance) from the sample to the source through the charged particle optical elements. The flow conductance may be reduced for example by providing a tube with a high aspect ratio such as a long narrow tube (i.e. a tube that is long relative to its cross-sectional size) between the charged particle optical elements and the source. The long narrow tube allows charged particles to pass through but has a relatively low flow conductance because of the relatively long length. However, the relatively long length undesirably increases the length of the charged particle optical path from the source to the sample, which may result in loss of brightness and consequential reductions in resolution and/or throughput. An alternative (or additional) approach is to guide the charged particle beam or multi-beam through a small aperture by using a beam cross-over. Such a small aperture may restrict the flow of gas towards the source. However, using a beam cross-over may also result in loss of brightness and undesirably reduce resolution and/or throughput and/or may be incompatible with some electron-optical designs.

### SUMMARY

It is an object of the present disclosure to provide methods and apparatus that at least partially address the challenges mentioned above, for example that limit unwanted flow of gas from the sample region to the source while avoiding or reducing loss of beam brightness at the sample.

According to an aspect of the invention, there is provided a charged particle device for projecting one or more beams of charged particles towards a sample, the device comprising: a charged particle optical element configured to direct one or more beams of charged particles towards a sample, the charged particle optical element comprising a plate in which is defined one or more beam apertures and a plurality of vent apertures; and a beam tube defining an inner tube volume comprising paths up-beam of the plate of charged particles of the one or more beams, and an outer tube region that is outside of the beam tube, wherein: the one or more beam apertures are configured for passage towards the sample of charged particles of the one or more beams, from the inner tube volume to a down-beam volume on an opposite side of the plate to the inner tube volume; and the vent apertures are configured to fluidically connect the down-beam volume to the outer tube region.

According to an aspect of the invention, there is provided a method of assessing a sample using charged particles, the method comprising: using a charged particle device to project one or more beams of charged particles towards a sample, wherein: the device comprises a charged particle optical element that directs the one or more beams towards the sample, the charged particle optical element comprising a plate in which is defined one or more beam apertures and a plurality of vent apertures; the device comprises a beam tube defining an inner tube volume comprising paths up-beam of the plate of charged particles of the one or more beams, and an outer tube region that is outside of the beam tube; the one or more beam apertures allow passage towards the sample of charged particles of the one or more beams, from the inner tube volume to a down-beam volume on an opposite side of the plate to the inner tube volume; the vent apertures are configured to fluidically connect the down-beam volume to the outer tube region; and the method comprises pumping fluid from the down-beam volume into the outer tube region via the vent apertures.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam charged particle apparatus that is part of the exemplary charged particle beam inspection apparatus of **FIG. 1****.**
**FIG. 3** is a schematic diagram of an exemplary charged particle apparatus comprising a condenser lens array, an objective lens array and a detector array.
**FIG. 4** is a schematic diagram of an exemplary charged particle apparatus comprising a macro collimator and a macro scan deflector.
**FIG. 5** is a schematic cross-sectional view of a portion of an objective lens array and detector array of an exemplary arrangement.
**FIG. 6** is a bottom view of the portion of the detector array of **FIG. 5****.**
**FIG. 7** is a bottom view of a modified version of the portion of the detector array of **FIG. 5****.**
**FIG. 8** is a schematic diagram of an exemplary charged particle apparatus comprising an objective lens array and a beam separator.
**FIG. 9** is a schematic diagram of an exemplary charged particle apparatus comprising a beam tube.
**FIG. 10** is a schematic diagram showing a portion of a charged particle device comprising a charged particle optical element and an adjacent beam tube.
**FIG. 11** is a schematic diagram showing a variation on the arrangement of **FIG. 10** in which a flow passage is defined at a higher position along the beam tube.
**FIG. 12** is a schematic top view of a portion of an exemplary plate of a charged particle optical element.
**FIG. 13** is a schematic top view of a portion of a further exemplary plate of a charged particle optical element.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000^{th} of a human hair. Thus, it is not surprising that semiconductor IC manufacturing is a complex and time-consuming process, with hundreds of individual steps. Errors in even one step have the potential to dramatically affect the functioning of the final product. Even a single defect can cause device failure in certain situations. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical device or column. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons. All references to charged particles may be considered to include at least electrons.

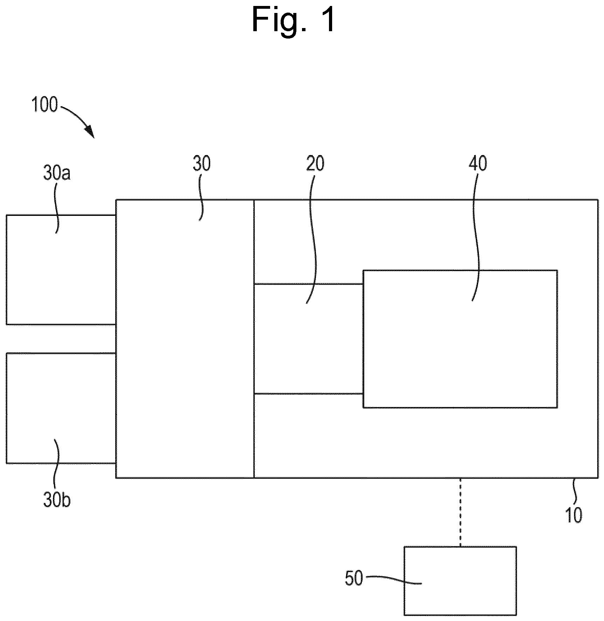

Reference is now made to **FIG. 1****,** which is a schematic diagram illustrating an exemplary charged particle beam inspection apparatus 100, which may also be referred to as a charged particle beam assessment system or simply assessment system. The charged particle beam inspection apparatus 100 of **FIG. 1** includes a main chamber 10, a load lock chamber 20, an electron beam apparatus 40, an equipment front end module (EFEM) 30 and a controller 50. The controller may be distributed between different components of the assessment system, including for example in the electron beam apparatus 40. Charged particle apparatus 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam apparatus by which it may be inspected. An charged particle apparatus 40 may comprise a multi-beam electron-optical apparatus.

Controller 50 is signally, for example electronically, connected to electron beam apparatus 40, for example as distributed components of the controller 50. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection apparatus, it should be noted that aspects of the disclosure in their broadest sense are not limited to a chamber housing an electron beam inspection apparatus. Rather, it is appreciated that the foregoing principles may also be applied to other systems and other arrangements of apparatus, that operate under the second pressure.

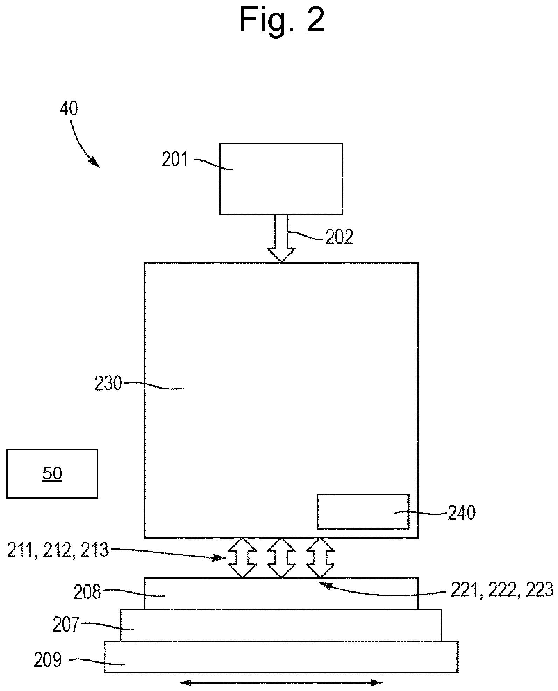

Reference is now made to **FIG. 2****,** which is a schematic diagram illustrating an exemplary charged particle apparatus 40. The charged particle apparatus 40 may be provided as part of the exemplary charged particle beam inspection system 100 of **FIG. 1****.** The charged particle apparatus 40 includes an electron source 201 and a charged particle column (or device) 230. The charged particle device 230 may be referred to or comprise a projection apparatus for directing a primary charged particle beam 202 towards a sample 208. The electron source 201 and associated and component charged particle optical elements may be referred to as an illumination apparatus for generating a primary charged particle beam 202. The assessment apparatus comprises a sample support that supports a sample 208. The sample support in this example comprises a sample holder 207. The sample holder 207 holds the sample 208 (e.g., a substrate or a mask) for assessment. The sample holder 207 is supported by a motorized or actuated stage 209. The charged particle apparatus 40 further comprises a detector 240. The detector 240 detects signal charged particles (e.g., electrons) from the sample 208. The detector 240 generates detection signals on detection of the signal charged particles.

The electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form the primary electron beam 202.

The charged particle device 230 is configured to convert primary electron beam 202 into a plurality of charged particle beams 211, 212, 213 and to direct each beam onto the sample 208. Although three beams are illustrated for simplicity, there may be many tens, many hundreds, many thousands, many tens of thousands, or even hundreds of thousands (or more) of beams. The beams may be referred to as beamlets or sub-beams. The plurality of charged particle beams may be referred to collectively as a multi-beam or beam grid. A beam grid with so many beams (e.g. more than a thousand beams) may have a field of view of e.g. more than 0.5mm, for example in the range of 0.5 to 30mm or 1 to 30 mm.

The controller 50 (for example control system comprising distributed controllers) may be connected to various parts of charged particle beam inspection apparatus 100 of **FIG. 1****,** such as the electron source 201, the electron detection device 240, the charged particle device 230, and actuated stage 209. The controller 50 may perform various image and signal processing functions. The controller 50 may also generate various control signals to govern operations of the charged particle beam inspection apparatus 100, including operations of the charged particle apparatus 40.

The charged particle device 230 may be configured to focus, for example, beams 211, 212, and 213 onto a sample 208 for inspection and may form three probe spots 221, 222, and 223 on the surface of sample 208. The charged particle device 230 may be configured to deflect primary beams 211, 212, and 213 to scan probe spots 221, 222, and 223 across individual scanning areas in a section of the surface of sample 208. In response to incidence of primary beams 211, 212, and 213 on probe spots 221, 222, and 223 on sample 208, electrons are generated from the sample 208 which include secondary electrons and backscattered electrons which may be referred to as signal charged particles. The secondary electrons typically have electron energy as large as fifty electron volts (≤ 50 eV) and backscattered electrons typically have electron energy between fifty electron volts (50 eV) and the landing energy of primary beams 211, 212, and 213.

The detector 240 may send the detection signals generated in the detector 240, for example as an imaging or detection signal, to the controller 50 or a signal processing system (not shown which may be part of the controller 50), e.g. to construct images of the corresponding scanned areas of sample 208. The detector 240 may be incorporated at least partly into the charged particle device 230 or may be separate therefrom, for example where a secondary optical column directs secondary electrons to the detector 240.

The controller 50 may comprise an image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive the detection signal from the detector 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample 208 based on an imaging signal received from the detector 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. A part of the controller for such a function may be comprised in or proximate to the detector. The electron distribution data, collected during a detection time window, can be used in combination with corresponding scan path data of each of primary beams 211, 212, and 213 incident on the sample surface to reconstruct images of the sample structures under inspection. The reconstructed images can be used to reveal various features of the internal or external structures of sample 208. The reconstructed images can thereby be used to reveal any defects that may exist in and/or on, thus of the sample.

The controller 50 may control actuated stage 209 to move sample 208 during inspection of sample 208, for example to provide a scanning motion of the stage relative to the paths of the primary beams. The controller 50 may enable actuated stage 209 to move sample 208 in a direction such as part of the scanning motion of the stage, preferably continuously, for example at a constant speed, at least during sample inspection. The controller 50 may control movement of the actuated stage 209 so that it changes the speed of the movement of the sample 208 dependent on various parameters. For example, the controller may control the stage speed (including its direction) depending on the characteristics of the inspection steps and/or scans of the scanning process for example as disclosed in EPA 21171877.0 filed 3 May 2021 which is hereby incorporated by reference in so far as the combined stepping and scanning strategy at least of the stage. In controlling the actuated stage, actuation of the stage and thus the sample may enable the sample to be positioned, for example dynamically, relative to the paths of the primary beams.

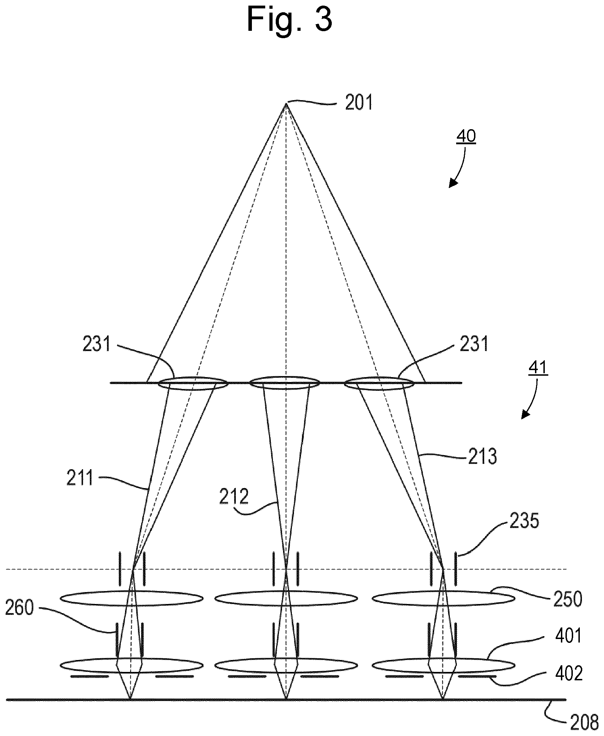

**FIG.** 3 is a schematic diagram of an exemplary charged particle apparatus 40 for use in an assessment apparatus. The charged particle apparatus 40 comprises a charge particle device 41 configured to project charged particles towards the sample 208. Such a charged particle device comprises all electron-optical elements that are intended to operate on charged particles between the source and sample. In the depicted arrangement all electron-optical elements are electrostatic; in a different arrangement one or more of the electron-optical elements may be magnetic. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged particle devices such as those discussed herein, it will be understood that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along a path of a beam grid of a plurality of charged particle beams (which may also be referred to as sub-beams). The electrodes are thus also in series along paths of charged particle beams of the beam grid.

Electron source 201 directs electrons toward an array of condenser lenses 231 forming part of charged particle device 230. The electron source 201 is desirably a high brightness thermal field emitter with a good compromise between brightness and total emission current. There may be many tens, many hundreds or many thousands or even tens of thousands of condenser lenses 231. Condenser lenses of array 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array may take the form of at least two, preferably three, plates, acting as electrodes, with apertures in each plate aligned with apertures in other plates to define paths for charged particle beams through the plates. At least two of the plates are maintained during operation at different potentials to achieve the desired lensing effect. Between the plates of the condenser lens array are electrically insulating plates, for example made of an insulating material such as ceramic or glass, with one or more apertures for the charged particle beams. Additionally or alternatively, one or more of the plates may feature apertures that each have their own electrode, for example with an array of electrodes around their perimeter or arranged in groups of apertures having a common electrode. In a variant, one or more of the plates may comprise multiple portions or strips with multiple apertures. In a further alternative arrangement, a macro collimator is provided instead of the condenser lens array. The macro collimator may act on the beam from the source 201 before the beam has been split into a multi-beam. The macro collimator may be implemented magnetically, electrostatically, or magnetically and electrostatically.

In some embodiments, the condenser lens array is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective beam 211, 212, 213 which is focused at a respective intermediate focus 233. A collimator or an array of collimators may be positioned to operate on the respective intermediate focuses 233. The collimators may take the form of deflectors 235 provided at the intermediate focuses 233. Deflectors 235 are configured to bend a respective beam 211, 212, 213 by an amount effective to ensure that the principal ray (which may also be referred to as the beam axis) is incident on the sample 208 substantially normally (i.e. at substantially 90° to the nominal surface of the sample). Note that in an arrangement with a macro condenser lens, the condenser lens may collimate or contribute to the collimation of the source beam or, in an embodiment, a plurality of beams.

An objective lens array 401 is provided down-beam from the deflectors 235. The objective lens array 501 comprises an objective lens for each beam 211, 212, 213. The objective lens array 401 projects the beams 211, 212, 213 onto the sample 208. The objective lens array 401 may comprise two or more, preferably at least three, plate electrode arrays connected to respective potential sources.

Optionally, a control lens array 250 is provided between the deflectors 235 and the objective lens array 401. The control lens array 250 comprises a control lens for each beam 211, 212, 213. The control lens array 250 provides additional degrees of freedom for controlling properties of the beams 211, 212, 213. The control lens array 250 may comprise two or more, preferably at least three, plate electrode arrays connected to respective potential sources. A function of control lens array 250 is to optimize the beam opening angle with respect to the demagnification of the beam and/or to control the beam energy delivered to the objective lenses, each of which directs a respective beam 211, 212, 213 onto the sample 208. In an embodiment the control lens array may be considered to be part of the objective lens, for example in being additional plates associated with the objective lens array.

Optionally an array of scan deflectors 260 is provided between the control lens array 250 and the objective lens array 401. The array of scan deflectors 260 comprises a scan deflector for each beam 211, 212, 213. Each scan deflector is configured to deflect a respective beam 211, 212, 213 in one or two directions to scan the beam across the sample 208 in one or two directions. Alternatively, a macro scan deflector may be provided to scan the charged particle beams over the sample 208. The macro scan deflector may be provided up-beam of the control lens array 250. In an embodiment such a macro scan deflector may operate on the source beam and may be present with a macro condenser lens.

A detector module 402 of a detector is provided within the objective lenses or between the objective lenses and the sample 208 to detect signal electrons/particles from the sample 208. An exemplary construction of such a detector module 402 is described below. Note that the detector additionally or alternatively may have detector elements up-beam along the primary beam path of the objective lens array 401 or even the control lens array 250. The detector module may be an array of detector elements (e.g. a detector array). Each element may be associated with an individual beam, for example positioned to detect signal particles generated by the individual beam.

The charged particle device 41 of **FIG. 3** may be configured to control the landing energy of electrons on the sample 208 by varying potentials applied to the electrodes of the control lenses and the objective lenses. The control lenses and objective lenses work together and may be referred to as an objective lens assembly. The landing energy can be selected to increase emission and detection of secondary electrons dependent on the nature of the sample being assessed. The detector module may be comprised in the objective lens assembly.

The objective lenses can be configured to demagnify the electron beam by a factor greater than 10, desirably in the range of 50 to 100 or more. The objective lenses may comprise three electrodes: a middle electrode, a lower electrode and an upper electrode. The upper electrode may be omitted. An objective lens having only two electrodes can have lower aberration than an objective lens having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beams.

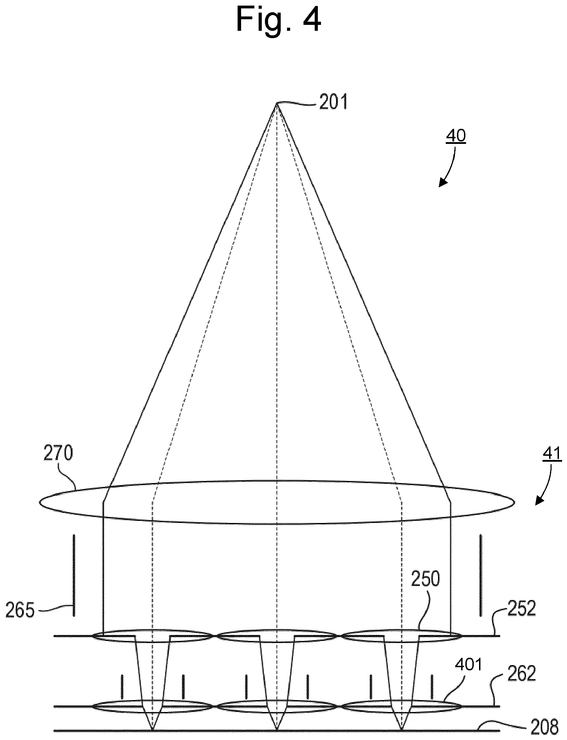

**FIG. 4** depicts a variation on the arrangement of **FIG. 3** in which the charged particle apparatus 40 comprises a macro collimator 270 and a macro scan deflector 265 instead of the condenser lenses 231 and deflectors 235 of **FIG. 3****.** Features that are the same as those described above are given the same reference numerals. For conciseness, such features are not described in detail with reference to **FIG. 4****.** For example, the source 201, the control lens array 250, the objective lens array 401 and the sample 208 may be as described above. The macro collimator 270 and/or the macro scan deflector 265 may be a macro lens that may be magnetic, electrostatic or both. The macro collimator 270 and the macro scan deflector 265 act on the beam before the beam is split to form the multi-beam. The macro collimator 270 and the macro scan deflector 265 may thus act on all of the beam rather than comprising arrays of elements configured to interact with different individual portions of the beam.

In the arrangement of **FIG. 4****,** a beam from the source 201 is split into multiple beams by a sub-beam forming array 252 defining an array of beam-limiting apertures. The objective lens array assembly in this embodiment further comprises a beam shaping aperture array 262 down-beam from the sub-beam forming array 252. The beam shaping aperture array 262 defines an array of beam-limiting apertures. The beam shaping aperture array 262 may shape beams defined by the sub-beam forming array 252. The use of two shaping aperture arrays is beneficial in situations in which use of only the sub-beam forming array 252 risks introducing aberrations into the beams. In a variation of the arrangement shown in and described with reference to **FIG. 4****,** the macro scan deflector may be replaced with a scan deflector array associated with the objective lens array and/or the macro condenser lens may be replaced with a collimator deflector array associated with the control lens array and/or the sub-beam forming array 252.

In some embodiments, the objective lens array assembly comprises a detector having a detector module 402 down-beam of at least one electrode of the objective lens array 401. The detector module 402 may comprise or even take the form of a detector array. In an embodiment, at least a portion of the detector is adjacent to and/or integrated with the objective lens array 401. For example, the detector module 402 may be implemented by integrating a CMOS chip detector into a bottom electrode of the objective lens array 401. Integration of a detector module 402 into the objective lens array may replace a secondary column. The CMOS chip is preferably orientated to face the sample (because of the small distance between sample and the bottom of the electron-optical system, which may for example be in the range of 10 to 400 micron, desirably in the range of 50 to 200 micron, optionally about 100 micron). It is noted that even in situations in which the detector is up-beam of the most down-beam electron-optical element of the charged particle device, there may be a close, e.g. of similar distance, separation between the most down-beam electron-optical element and the sample (e.g. about 100 micron). In an embodiment, electrodes to capture the signal charged particles are formed in the top metal layer of the CMOS device. The electrodes can be formed in other layers of the substrate, e.g. of the CMOS chip. Power and control signals of the CMOS may be connected to the CMOS by through-silicon vias. For robustness, preferably the bottom electrode consists of two elements: the CMOS chip and a passive Si plate with holes. The plate shields the CMOS from high E-fields.

In an embodiment, a single electrode surrounds at least some of the apertures. In an arrangement a single electrode is assigned for example around each aperture. In another embodiment, a plurality of electrode elements are provided around each aperture for example as a detector element. The signal charged particles captured by the electrode elements surrounding one aperture may be combined into a single detection signal or used to generate independent detection signals. The electrode elements may be divided radially (i.e., to form a plurality of concentric annuluses), angularly (i.e., to form a plurality of sector-like pieces), both radially and angularly (providing an arrangement like a dart board), or in a grid (for example as a chess board) or in any other convenient manner.

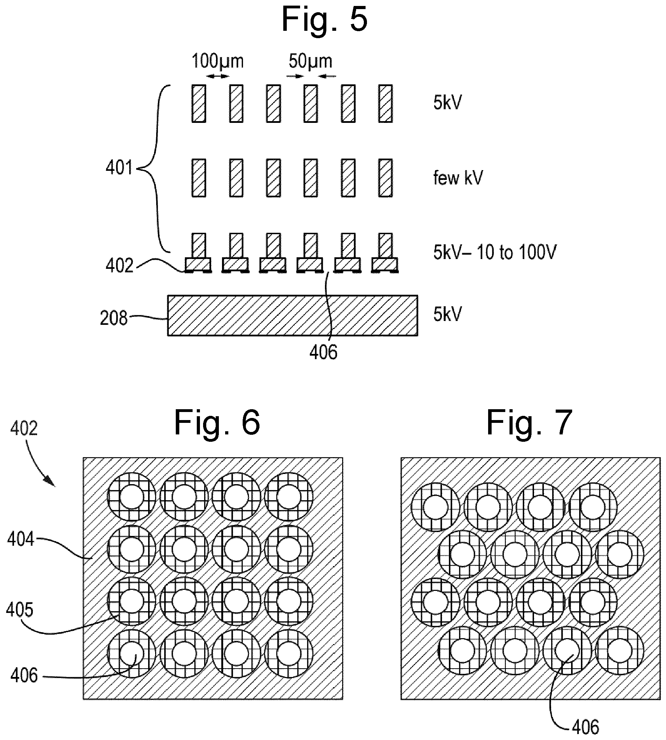

An exemplary embodiment of a detector integrated into an objective lens array 401 is shown in **FIG. 5****,** which illustrates a portion of an objective lens array 401 in schematic cross section. In this embodiment, the detector comprises a detector module 402 comprising a plurality (e.g., an array) of detector elements 405 (shown in **FIG. 6****),** for example sensor elements such as capture electrodes, preferably as an array of detector elements (i.e. a plurality of detector elements in a pattern or arrangement preferably over a two dimensional surface). In this embodiment, the detector module 402 is provided on an output side of the objective lens array. The output side is the output side of the objective lens array 401. **FIG. 6** is a bottom view of detector module 402 which comprises a substrate 404 on which are provided a plurality of detector elements (or capture electrodes 405) each surrounding a beam aperture 406. The beam apertures 406 may be formed by etching through substrate 404. In the arrangement shown in **FIG. 6****,** the beam apertures 406 are shown in a rectangular array. The beam apertures 406 can also be differently arranged, e.g. in a hexagonal close packed array as depicted in **FIG. 7****.**

The integrated detector module 402 described above is particularly advantageous when used with an assessment apparatus (e.g. comprising a device) having tunable landing energy because secondary electron capture can be optimized for a range of landing energies. A detector module having or in the form of an array can also be integrated into other electrode arrays, not only the lowest electrode array. Further details and alternative arrangements of a detector module integrated into an objective lens can be found in EP Application Number 20184160.8, which document is hereby incorporated by reference.

An electric power source may be provided to apply respective potentials to electrodes of the control lenses of the control lens array 250 and the objective lenses of the objective lens array 401 and the condenser lenses of the condenser lens array or any electron-optical component of the charged particle device 41 for example the detector module (such as when integrated into the objective lens array or when the objective lens and detector module are separate components). A controller 50 may control the potentials applied to the electron-optical components such as the electrodes of the condenser lens array, objective lens array and/or control lens array.

The charged particle device 41 may comprise other charged particle optical (e.g., electron-optical) components such as charged particle correctors, for example as corrector arrays for alignment of the source to the sample and between beams of the multi-beam and for adjusting the focus of different groups of the beam grid, or individual beams of the beam grid. Such correctors may be controlled to operate dynamically and/or statically, for example during step-up, servicing or during calibration of the charged particle device 41.

In an embodiment, an array of charged particle devices (or device array) is provided. The array may comprise a plurality of any of the charged particle devices (e.g., electron-optical columns) described herein. Each of the charged particle devices in the array focuses respective pluralities of charged particle beams onto different regions of the same sample 208. Each charged particle device in the array may derive a respective plurality of charged particle beams from a different respective source 201. Each respective source 201 may be one source in a plurality of sources 201. At least a subset of the plurality of sources 201 may be provided as a source array. The source array may comprise a plurality of emitters on a common substrate. The focusing of pluralities of charged particle beams from different charged particle devices simultaneously onto different regions of the same sample allows an increased area of the sample 208 to be exposed to charged particle beams simultaneously. Therefore, an increased area of the sample may be processed (e.g. assessed) at one time. The charged particle devices in the device array may be arranged adjacent to each other so as to project the respective pluralities of beams onto adjacent regions of the sample 208. Any number of charged particle devices may be used in the array. Preferably, the number of charged particle devices is in the range of 9 to 200. Each charged particle device in the array may be configured in any of the ways described herein when referring to a single charged particle device, electron-optical device or system or column. Alternatively or additionally, one or more of the charged particle device in the array may be configured to project a single beam.

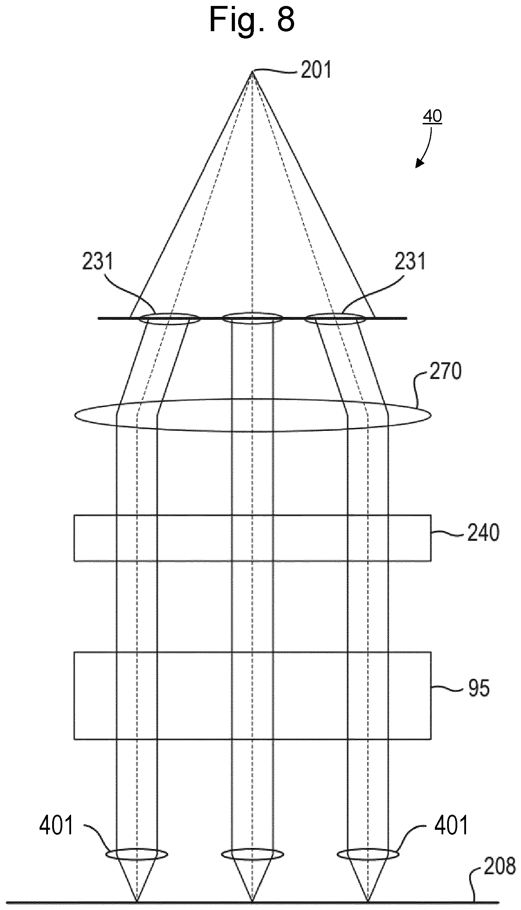

**FIG. 8** schematically depicts a further example of a charged particle apparatus 40 having a charged particle device 41. Features that are the same as those described above are given the same reference numerals. For conciseness, such features are not described in detail with reference to **FIG. 8****.** For example, the source 201, the condenser lenses 231, the objective lens array 401 and the sample 208 (e.g., on a sample support 207) may be as described above. In another arrangement the condenser lens 231 may be an '*aperture lens*'*.* The aperture lens may comprise a macro lens element and a a beam limiting aperture array to generate the sub-beams. The macro lens element may be positioned upbeam of the beam limiting aperture array. The aperture lens may operate to focus the sub-beams into an intermediate focus plane. In this example, a macro collimator 270 is provided instead of a deflector array of the type described above with reference to **FIG. 3****.** Such a macro collimator may be a macro lens that may be magnetic, electrostatic or both. In other embodiments, a deflector array may be used to at least contribute to the collimation of the beams, so the deflector array is for finer deflection towards collimation than the action of the macro collimator 270. Such an arrangement may also comprise an array of multiple deflectors (for example in which each aperture has multiple electrodes) for even finer collimation. In an arrangement the condenser lenses 231 may comprise a single plate defining a beam limiting aperture array in which are defined a plurality of apertures with one or more associated macro electrodes with a single aperture. Such a beam limiting aperture array and an associated macro electrode may also form a condenser lens array to focus the generated beams in an intermediate focus which desirably corresponds to the position of the collimator 270.

As described above, in some embodiments a detector may be provided between the objective lens array 401 and the sample 208. The detector may face the sample 208. Alternatively, as shown in **FIG. 8****,** the detector 240 may be implemented such that the objective lens array 401 is between the detector 240 and the sample 208.

In an embodiment a deflector array 95 is provided between the detector 240 and the objective lens array 401. In an embodiment the deflector array 95 comprises a Wien filter array so that deflector array 95 may be referred to as a beam separator. The deflector array 95 is configured to provide a magnetic field and an electrostatic filed. The electrostatic and magnetic fields operate together to separate the charged particles projected to the sample 208 relative to the signal particles e.g. electrons from the sample 208. The operation of the fields directs the signal particles towards the detector 240.

In an embodiment the detector 240 is configured to detect signal particles by reference to the energy of the charged particle, i.e. dependent on a band gap, such a semiconductor based type of detector. Such a detector 240 may be called an indirect current detector. The secondary electrons emitted from the sample 208 gain energy from the fields between the electrodes. The secondary electrons have sufficient energy once they reach the detector 240. In a different arrangement the detector 240 may be an electron to photon converter such as a scintillator array, for example of fluorescing strip between the beams that are positioned up-beam along the primary beam path with respect to the Wien filter. Primary beams passing through the Wien filter array (of magnetic and electrostatic strips orthogonal to the primary beam path) have paths upbeam and downbeam of the Wien filter array that are substantially parallel, whereas signal electrons from the sample are directed by the Wien filter array towards the scintillator array. The electron to photon converter may be photonically coupled to a photon to electron converter to convert any photons generated in and emitted by the electron to photon converter. The photon to electron converter may be electrically connected to electronic circuitry to process a detection signal. In different embodiments the photon to electron converter may be within or external to the charged particle device. In an embodiment photon coupling may be by via a photon transport unit (e.g., an array of optical fibers) to a remote optical detector which generates a detection signal on detection of a photon.

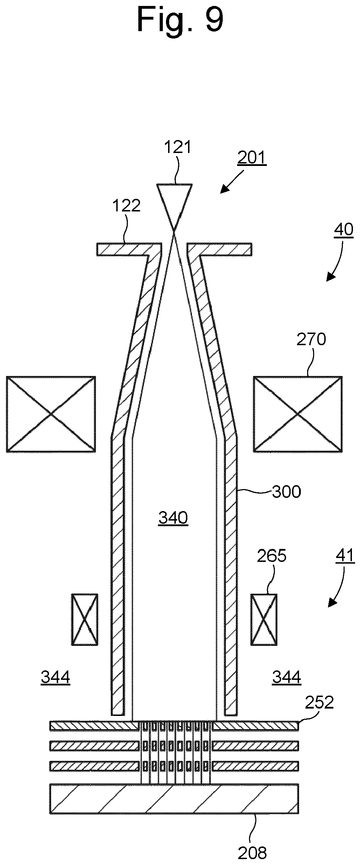

As shown in **FIG. 9****,** in an embodiment the charged particle apparatus 40 comprises a beam tube 300 (which may also be called a tube, liner tube, or booster tube). In an embodiment the beam tube 300 is arranged to surround the multi-beam path. The beam tube 300 surrounds the paths of charged particles. The charged particles may be a source beam emitted from the source 121 towards a sample. The charged particles may be of a plurality of beams of the multibeam. The beam tube 300 may surround the source beam path or the multi-beam path for example when viewed along the primary axis of the charged particle apparatus 40, i.e. in the direction of the charged particle beam. In an embodiment the beam tube 300 is configured to surround only part of the charged particle path, i.e. part of the charged particle path along the length of the charged particle path for example a length along part of the charged particle path . For example, as shown in **FIG. 9****,** in an embodiment the beam tube 300 surrounds the part of the multi-beam path from the source 201 to just above the sub-beam forming array 252. In other embodiments, the beam tube 300 surrounds different portions, e.g. lengths, of the multi-beam path.

In an embodiment the beam tube 300 is configured to operate at a first potential difference from ground. A support may be configured to support the sample 208 at a second potential difference from ground or at ground. The first potential difference may be greater than the second potential difference and such as to accelerate the charged particles of the multi-beam towards the sample 208. Arranging for the potential difference between the sample and the immediate environment to be relatively low may reduce the possibility of electrical breakdown in the vicinity of the sample 208. This can reduce the possibility of the sample 208 being damaged. The risk of damage to components of the charged particle device 41 such as the detector 240 (which may feature delicate electronic elements) may be reduced.

As explained above and exemplified in **FIG. 9****,** the electron source 201 may comprise a cathode 121 and an anode 122 (which may also be called an extractor or an extractor electrode). The cathode 121 and the anode 122 are configured to operate with a potential difference between them. The cathode 121 is configured to emit the charged particle beam. The anode 122 is configured to accelerate the charged particle beam towards the sample 208. Note, this source arrangement is a simplified arrangement. The source 201 may have a different arrangement and other electrodes, so long as the source 201 has a most down-beam source electrode, which is here referred to as the anode 122.

As shown in **FIG. 9****,** in an embodiment the beam tube 300 is electrically connected to the anode 122. By electrically connecting the beam tube 300 to the anode 122, there is no electric field formed between the source 201 and the beam tube 300. Any unwanted lensing effect up-beam of the beam tube 300 is avoided. The beam tube 300 may be formed together with the anode 122. The beam tube 300 and the anode 122 may be integral. Alternatively, the beam tube 300 may be separated from the source 201. The beam tube 300 may be distanced along the axial direction from the anode 122.

As shown in **FIG. 9****,** in an embodiment at least part of the charged particle device 41 is down-beam of the most down-beam end of the beam tube 300. For example, the sub-beam forming array 252, the control lens array 250, the objective lens array 241 and the beam shaping aperture array 262 may be provided down-beam of the beam tube 300. In an embodiment, the part of the charged particle device 41 down-beam from the beam tube 300 may be configured to decelerate the charged particle beam. The part of the charged particle device 41 down-beam from the beam tube 300 may be referred to as a charged particle optical element.

In an embodiment, the charged particle apparatus 40 is configured such that the charged particle beam passes through the charged particle apparatus 40 without undesirable lensing effects being applied to the beam. The down-beam end of the beam tube 300 may be configured to be in a region that has a small electric field or no electric field. This can help reduce or avoid any lensing effect on the charged particle beam that could be caused by an electric field between the beam tube 300 and any parts of the charged particle device 41 down-beam of the beam tube 300.

As shown in **FIG. 9****,** in an embodiment the beam tube 300 is spaced apart from the part of the charged particle device 41 down-beam of the beam tube 300. The separation may make it easier to manufacture the charged particle apparatus (by easing tolerances) and/or to replace part or all of the charged particle device 41. In an embodiment the separation is at most 1mm. Any electric field between the beam tube 300 and any part of the charged particle device 41 down-beam of the beam tube 300 may be confined to a small distance. This arrangement may help to reduce or even prevent the effect of any electric field between the beam tube 300 and a part of the charged particle device down-beam of the beam tube 300.

In an alternative embodiment the beam tube 300 is electrically connected to the part of the charged particle device 41 that is down beam of the beam tube 300. For example, the beam tube 300 may be structurally connected to and/or integral with the associated plate, for example the sub-beam forming array 252.

In the example of **FIG. 9****,** a macro collimator 270 comprising a magnetic component is provided, for example as part the charged particle device 41. The magnetic component can influence trajectories of charged particles within the beam tube 300 while being located outside of the beam tube 300.

In an alternative embodiment the macro collimator 270 comprises an electrostatic component. Such an electrostatic component may be affected by the beam tube 300, for example its shielding of electrostatic fields external to the beam tube 300. In an embodiment the electrostatic component of the macro collimator 270 is located within the beam tube 300 (not shown) or between lengths or sections of the beam tube (see EP Application 21199203.7 filed 27 September 2021, hereby incorporated by reference at least so far as designs comprising electron-optical elements and a beam tube and its sections).

In an embodiment the charged particle device 41 comprises a macro scan deflector 265. The macro scan deflector 265 is configured to deflect respective portions of the charged particle beam. The respective portions correspond to different sub-beams further down-beam. Deflection of the portions by the macro scan deflector 265 thus causes deflection of the respective sub-beams of charged particles, in the multi-beam, to be scanned relative to, for example over, the sample 208. As shown in **FIG. 9** in an embodiment the macro scan deflector 265 is up-beam of the down-beam end of the beam tube 300.

As shown in **FIG. 9****,** in an embodiment the macro scan deflector 265 comprises a magnetic deflector. The macro scan deflector 265 may be located outside of the beam tube 300.

In an alternative embodiment a scan deflector comprising an array of deflectors may be provided instead of a macro scan deflector. Such an array of deflectors is provided within the charged particle device 41 as an array of scan deflectors 260 as depicted in **FIG. 3****.** Such an array of scan deflectors may be associated with an objective lens array, for example in which a deflector of the array is associated with each beam of the multi-beam.

In the embodiment shown in **FIG. 9****,** the beam tube 300 extends continuously from a position close to the sub-beam forming array 252 to the source 122. When the beam tube 300 is metallic (or is coated with a metallic material) this will shield the interior of the beam tube 300 from electrostatic fields generated outside of the beam tube 300. As explained above, elements may be provided for manipulating charged particle trajectories within the beam tube 300 either via magnetic fields generated outside of the beam tube 300 or via magnetic or electrostatic fields generated within the beam tube 300. A further possibility, not shown, is to provide gaps in the beam tube 300 to allow electric fields generated outside of the beam tube to influence charged particle trajectories within the beam tube 300.

As mentioned in the introductory part of the description, it is desirable to minimize flow of gas through charged particle optical elements towards the charged particle source. This can be achieved by introducing elements having low flow conductance (e.g., a long narrow tube) or by using a beam cross-over to direct charged particles through a small aperture, but both approaches can result in a loss of brightness and undesirably reduce throughput. Embodiments described below aim to address these issues.

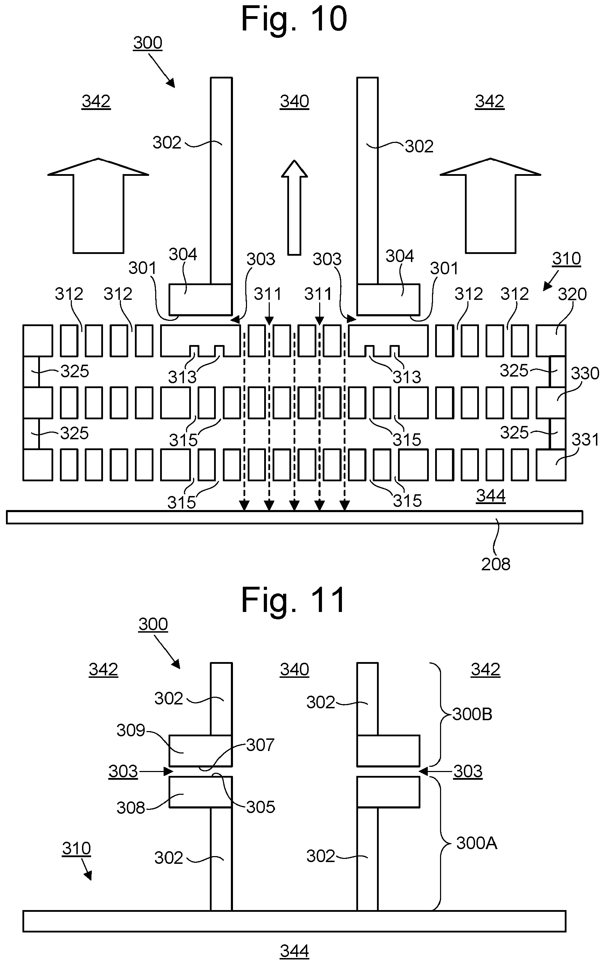

In an embodiment, as exemplified in **FIG. 10-13****,** there is provided a charged particle device 41 for projecting charged particles towards a sample 208. The charged particle device 41 may take any of the forms described above with reference to **FIG. 3****,** **4****,** **8** and **9****.** The charged particle device 41 comprises a charged particle optical element 310 (e.g., an electron-optical element). The charged particle optical element 310 is configured to direct one or more beams of charged particles towards the sample 208. In the example shown, the charged particle optical element 310 is configured to direct a plurality of beams of charged particles towards the sample 208. The plurality of beams of charged particles may be referred to as a multi-beam or beam grid. In other embodiments, the charged particle optical element 310 may be configured to direct a single beam towards the sample 208.

The charged particle optical element 310 comprises a plate 320 in which is defined one or more beam apertures 311 and a plurality of vent apertures 312. Representative examples of beam apertures 311 and vent apertures 312 are labelled in **FIG. 10** (not all of the respective apertures are labelled). The beams of charged particles pass through the beam apertures 311, as depicted schematically by the broken line arrows in **FIG.10****.** In an embodiment, the plate may be a sub-beam forming array 252, as described above with reference to **FIG. 4** and **9** for example.

The charged particle device 41 comprises a beam tube 300. The beam tube 300 may take any of the forms described above with reference to **FIG. 9** or other forms. The beam tube 300 may be metallic (or have a metallic coating) to provide electrostatic shielding. Alternatively or additionally, the beam tube 300 may be configured to shield magnetic fields, for example by comprising, consisting essentially of, or consisting of a magnetic shielding material, such as a material having very high relative permeability (e.g., greater than 50,000), such as a mu-metal. The beam tube 300 defines an inner tube volume 340. The inner tube volume 340 comprises (e.g., surrounds and/or contains) paths up-beam of the plate 320 of charged particles of the one or more beams (before or after the beams are formed) such as of a source beam prior to generation of the multiple beams, or the primary beams of the multi-beam. In embodiments where the charged particle optical element 310 is configured direct a plurality of beams towards the sample, which may be referred to as a multi-beam or beam grid, the beams may be formed before or after the charged particles of the beam reach the end of the beam tube 300. Thus, the paths of the charged particles in the beam tube 300 may or may not be arranged, for example grouped, into separate beams at this stage. The beam tube 300 further defines an outer tube region 342 that is outside of the beam tube 300. Thus, the beam tube 300 separates a volume inside of the beam tube (referred to as an inner tube volume) from a region outside of the beam tube (referred to as an outer tube region). The outer tube region 342 could also be referred to as an outer tube volume and will in practice be within a vacuum chamber and may be partially defined by walls of the vacuum chamber.

The beam apertures 311 are configured to allow passage towards the sample 208 of charged particles of the one or more beams, from the inner tube volume 340 to a down-beam volume 344. The beam apertures 311 thus fluidically connect the inner tube volume 340 to the down-beam volume 344. Thus, the beam apertures 311 provide a route for gas to flow from the down-beam volume 344 to the inner tube volume 340. The down-beam volume 344 is down-beam of the plate 320 on an opposite side of the plate 320 to the inner tube volume 340. The down-beam volume 344 may include a portion adjacent to the sample 208. It may be undesirable for gas to flow from the down-beam volume 344 to the inner tube volume 340 but the beam apertures are needed to allow the beams to propagate to the sample 208.

The vent apertures 312 are configured to fluidically connect the down-beam volume 344 to the outer tube volume 342. Thus, the vent apertures 312 provide a route for gas to flow from the down-beam volume 344 to the outer tube volume 342. As explained above, outgassing and/or charged particle stimulated desorption (e.g., electron-stimulated desorption, ESD) may cause relatively large amounts of gas to be present near the sample 208 and in portions of the charged particle device 41 near the sample 208. Providing an additional route for gas to flow out of the down-beam volume 344 helps to reduce the proportion of this gas that flows through the beam apertures 311 and into the inner tube volume 340. Reducing the flow of gas into the inner tube volume 340 reduces the amount of gas that reaches a region near the source 201 and thereby facilitate maintenance of a suitably low pressure (e.g., an ultrahigh vacuum) in the region of the source 201.

In an embodiment, a total flow conductance through the plate 320 provided by the vent apertures 312 is larger than a total flow conductance through the plate 320 provided by the one or more beam apertures 311. This helps to provide a larger flow of gas through the plate 320 into the outer tube region 342 (as indicated schematically by the two large solid arrows in the outer tube region 342) than through the plate 320 into the inner tube volume 340 (as indicated schematically by the small solid arrow in the inner tube volume 340). In an embodiment, a total open area of the vent apertures 312 (e.g., a sum of the cross-sectional areas of the vent apertures 312) is larger than a total open area of the one or more beam apertures 311 (e.g., a sum of the cross-sectional areas of the beam apertures 311). In a case where the vent apertures 312 and the beam apertures 311 have the same sizes, there may therefore be a larger number of the vent apertures 312 than beam apertures 311. Typically, the thickness of the plate 320 may be constant, in which case the flow conductance of the beam apertures 311 relative to the vent apertures 312 will be determined by the respective total areas. This will also be approximately the case when the thickness of the plate 320 is very small in comparison with the sizes of the apertures. In cases where the thickness of the plate 320 is relatively large in comparison with the aperture sizes and varies as a function of position, it may be necessary to consider also the effects on flow conductance from differences in the lengths of flow paths through the apertures. For example, if a portion of the plate 320 where the vent apertures are defined is thicker than a portion of the plate 320 where the beam apertures are defined it may be necessary to provide more vent apertures to ensure that the total flow conductance through the plate 320 provided by the vent apertures 312 remains higher than the total flow conductance through the plate 320 provided by the beam apertures 311. Conversely, if the thickness of the plate 320 is made smaller where the vent apertures are defined then fewer vent apertures 312 may be needed to provide the required higher flow conductance.

In an embodiment, the one or more beam apertures 311 and the plurality of vent apertures 312 consist of apertures having a common dimension (e.g., common diameter, or common width, for example in the case where apertures are formed between strip electrodes), common shape (e.g., circular or rectangular) and/or common cross-sectional area. Thus, the apertures may all have the same form. Arranging for the beam and vent apertures to have the same form may facilitate the manufacturing process, particularly where the apertures are formed using microelectromechanical system (MEMS) manufacturing techniques and processing.

In an embodiment, a plurality of the beam apertures 311 is provided and an average separation between the beam apertures 311 is equal to an average separation between the vent apertures 312. The beam apertures 311 may, for example, be arranged in an aperture pattern having an aperture pitch. The vent apertures 312 may be arranged in a vent pattern having a vent pitch. The aperture pattern and the vent pattern may comprise respective two-dimensional arrays, optionally regular arrays. Optionally, the aperture pattern and the vent pattern are arranged in arrays of the same type, for example: same pitch; same array symmetry (e.g., hexagonal, rectangular, etc.); and/or same array orientation. The aperture pitch and the vent pitch may be equal. Arranging the beam and vent apertures in similar or identical patterns may facilitate the manufacturing process, particularly where the apertures are formed using MEMS manufacturing techniques.

In an embodiment, the beam tube 300 comprises a facing surface 301. The facing surface 301 is spaced apart from the plate 320 of the charged particle optical element to define a flow passage 303. The facing surface 301 faces the plate 320. The facing surface 301 may be the portion of the beam tube 300 that is most down-beam (e.g., closest to the sample 208). The flow passage 303 is configured (e.g., dimensioned) to restrict flow between the inner tube volume 340 and the outer tube region 342. The gap between the facing surface 301 and the plate 320 so defining the flow passage 303 may be considered to be a restriction. The flow passage 303 may thus be configured to provide a relatively high flow resistance (low flow conductance). The flow passage 303 may thus be relatively narrow (e.g., the facing surface 301 may be spaced apart from the plate 320 by a relatively small distance). The flow passage 303 may be relatively long in the lateral direction (e.g., along the direction of a flow path through the flow passage 303 between the inner tube volume 340 and the outer tube region 342). In an embodiment, the facing surface 301 has an annular shape (e.g., when the beam tube 300 is cylindrical).

Providing a separation between the beam tube 300 and the plate 320, rather than connecting the beam tube 300 to the plate 320, facilitates manufacture by reducing the need for fine tolerances and makes it easier to replace components. Providing a separation that defines a flow passage 303 with low flow conductance minimizes undesirable flow of gas from the outer tube region 342 to the inner tube volume 340. The restriction defined by the surfaces of the flow passage therefore effectively separates the volumes within the inner tube volume 340 and the outer tube region 342.

In an embodiment, as exemplified in **FIG. 10****,** the beam tube 300 comprises a flange portion 304 and the facing surface 301 is defined by the flange portion 304. Providing a flange portion locally increases the thickness of the beam tube 300 and thereby increases a length of the flow path through the flow passage 303 (thereby increasing the flow resistance). In an embodiment, the flange portion 304 extends further from the paths of charged particles (e.g., further from a principal axis of the beam or multi-beam propagating within the beam tube 300) than an adjacent portion of the beam tube 300. The beam tube 300 may comprise a wall 302. The flange portion 304 may extend further from the paths than an outmost portion of the wall. The flange portion 304 may extend further from the path than an outermost portion of the wall 302 adjacent to the flange portion 304.

In an embodiment, a passage surface of the plate 320 defining the flow passage 303 (e.g., the portion of the uppermost surface of the plate 320 that is facing the facing surface 301 of the beam tube 300 in **FIG. 10****)** is coplanar with a surface of the plate 320 defining openings to the beam apertures 311 (e.g., the portion of the uppermost surface of the plate 320 that faces into the inner tube volume 340). The passage surface is thus on a plate side of the flow passage 303.

In an embodiment, the plate 320 comprises a protrusion and a surface defining the flow passage on a plate side of the flow passage is provided by the protrusion. In this case, a passage surface of the plate 320 defining the flow passage may be non-coplanar with the surface of the plate 320 defining openings to the beam apertures 311.

In an embodiment, as exemplified in **FIG. 11****,** the beam tube 300 comprises a proximal part 300A and a distal part 300B. The proximal part 300A is connected to the plate 320. The distal part 300B is positioned on a distal side of the proximal part 300A relative to the plate 320. The proximal part 300A and distal part 300B comprise respective facing surfaces 305, 307. The facing surfaces 305, 307 are spaced apart from each other to define a flow passage 303. The flow passage 303 is configured (e.g., dimensioned) to restrict flow between the inner tube volume 340 and the outer tube region 342. The gap between the facing surface 301 and the plate 320 so defining the flow passage 303 may be considered to be a restriction. The restriction of flow may be achieved using any of the approaches described above for the flow passage 303 with reference to **FIG. 10****.** The proximal part 300A and the distal part 300B may comprise respective flange portions 308, 309 that comprise the facing surfaces 305 and 307. The flange portions may be configured in any of the ways described above for the flange portion 304 with reference to **FIG. 10****.** The restriction defined by the facing surfaces 305, 307 of the flow passage between the flange portions 308, 309 therefore effectively separates the volumes within the inner tube volume 340 and the outer tube region 342.

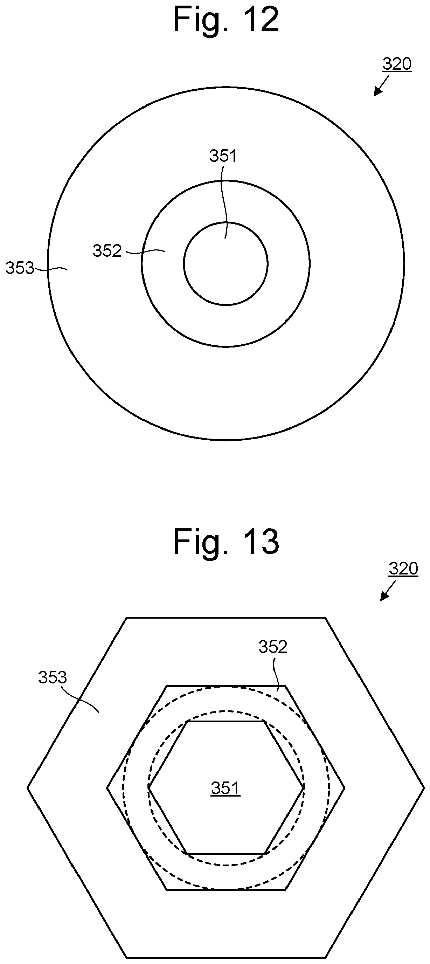

In an embodiment, as depicted in **FIG. 12** and **13****,** a surface of the plate 320 on an up-beam side of the plate 320 (e.g., the uppermost side of the plate 320 as depicted in **FIG. 10** and **11****,** which is the uppermost side of the electron-optical element 310) has a central region 351, a peripheral region 353 surrounding the central region 351, and a buffer region 352 between the central region 351 and the peripheral region 353. The buffer region 352 separates the central region 351 from the peripheral region 353. The one or more beam apertures 311 are defined in the central region 351. The plurality of vent apertures 312 are defined in the peripheral region 353. The buffer region 352 surrounds the central region 351 and has a finite radial thickness (e.g., relative to a principal axis of the beam or beams propagating through the beam tube 300) at all azimuthal angles. The central region 351 is thus separated from the peripheral region 353 in all radial directions. In an embodiment, at least a portion of the facing surface 301 of the beam tube 300 faces the buffer region 352. The facing surface 301 and the buffer region 352 may define surfaces of the flow passage 303. The facing surface 301 and the buffer region 352 may defined a flow restriction for preventing, or otherwise limiting, the gas flow between the inner tube volume 340 and the outer tube region 342 so they are separate. In an embodiment, all of the facing surface 301 faces the buffer region. In an embodiment, the buffer region 352 is an aperture free region of the surface. Reducing the number of apertures (or avoiding having any apertures) that open out into the flow passage 303 may promote a desired restriction of flow of gas via the flow passage 303 into the inner tube volume 340. That is surface which is smooth aids a smooth flow of gas unlike a surface featuring recesses. Apertures opening into the flow passage 303 might otherwise provide a shortcut for gas to flow into the inner tube volume 340 from the down-beam volume 344.

The central region 351, buffer region 352, and peripheral region 353 may take various forms. Their shapes may be dictated for example by geometrical choices for a multi-beam. **FIG. 12** and **13** depict two examples. In **FIG. 12****,** the central region 351, buffer region 352, and peripheral region 353 are circular and concentric with each other. This arrangement conveniently facilitates alignment with the beam tube 300, which may typically be cylindrical for example of circular cross-section. For example, this arrangement facilitates alignment of a large portion or all of the buffer region 352 with the facing surface 301 of the beam tube 300. In **FIG. 13****,** the central region 351, buffer region 352, and peripheral region 353 are hexagonal. Hexagonal geometries may be desirable for some multi-beam arrangements. In this case, in an embodiment, a facing surface 301 of a cylindrical beam tube only faces a portion of the buffer region 352, as indicated by the concentric broken line circles in **FIG. 13****.**

In an embodiment, the plate 320 defines a plurality of blind holes 313 opening into the down-beam volume 344, as depicted in **FIG. 10****.** The blind holes 313 are recesses defined in a surface of the plate 320 for example a sample facing surface of the plate which may be desirably to avoid affecting any gas flow over the surface of the plate 320 and over the charged particle optical element 310. Alternatively the holes may be through-holes through the plate 310 instead of blind holes 313 but this may be less preferred because of the risk of gas flow through the through-holes, i.e. additional conductance such through-holes provide. The blind holes 313 (or other holes) may be configured to operate as field distortion suppressing apertures. The field distortion suppressing apertures (e.g., blind holes) are configured to suppress distortions in the electrical field of peripheral beam apertures of the plurality of beam apertures 311 relative to more centrally located beam apertures. The field distortion suppressing apertures may make the environment of the peripheral beam apertures (which do not have any beam apertures 311 radially outside of them) more similar to the environment of the more centrally located beam apertures (which do have beam apertures radially outside of them). Spacings between the field distortion suppressing apertures and the peripheral beam apertures may thus be made substantially the same as spacings between the peripheral beam apertures and more centrally located beam apertures.

In an embodiment, as exemplified in **FIG. 10****,** at least a subset of the blind holes 313 are positioned opposite to the buffer region 352 (e.g., at X and Y coordinates within the buffer region 352, relative to a plane parallel to the plate 320, but on the opposite side of the plate 320). As also exemplified in **FIG. 10****,** at least a subset of the blind holes 313 may be positioned opposite the facing surface 301 of the beam tube 300 on the other side of the plate 320 from the beam tube 300. The plurality of blind holes 313 may have a same dimension (e.g., diameter), shape (e.g., circular) and/or cross-sectional area as either or both of the one or more beam apertures 311 and the plurality of vent apertures 312.

In an embodiment, as exemplified in **FIG. 10****,** the charged particle device 41 further comprises at least one further plate down-beam of and coplanar with the plate 320. In the example shown, two further plates 330 and 340 are provided. One of the further plates (further plate 340 in the example shown) provides a facing surface for facing a sample 208. Defined in one or more of the further plates may be one or more beam apertures and a plurality of vent apertures. In an embodiment, one or more of the vent apertures of the plate 320 are aligned with one or more of the vent apertures in one or more further plates. In other embodiments, the vent apertures may be unaligned. Providing vent apertures in multiple plates facilitates flow of gas from the region adjacent the sample 208 to the vent apertures 312 in the plate 320. The plate 320 and the one or more further plates may be configured to operate at different potentials to manipulate trajectories of charged particles as desired, for example by providing lensing effects and/or decelerating the charged particles. The plate 320 and the one or more further plates may comprise a control lens array and/or an objective lens array and/or a detector according to any of the arrangements described above. One or more of the plates may comprise a deflector array for example as a scan deflector or a collimator deflector array. One or more of the plates may comprises a corrector array as an array of strip electrodes or an array of multipole correctors with individually controllable electrodes. The stack of plates may thus have any suitable design such as described with reference to and depicted in **FIG. 3****,** **4** **and** **8****.** Field distortion suppressing apertures (blind or open) may be provided in any or all of the further plates, particularly where the further plates 330 and 340 are configured to provide lensing effects that might otherwise be disrupted for peripheral beam apertures in the respective further plates. The field distortion suppressing apertures in the further plates 330 and 331 may be aligned (e.g., along longitudinal axes of the apertures) with the field distortion suppressing apertures provided in the plate 320. In the example of **FIG. 10****,** open (not blind) field distortion suppressing apertures 315 (or through-holes) are provided in the further plates 330 and 331.

In an embodiment, the charged particle device 41 further comprises a detector. The detector may take any of the forms described above, including with reference to **FIG. 5** to **7****.** The detector is configured to detect signal charged particles from the sample 208. The detector may be positioned between the plate 320 and the sample 208. The detector may provide a facing surface of the charged particle device 41 for facing a sample. That is at a down-beam most position for facing a sample, at an up-beam most position adjoining the tube 300 for example comprised in or associated with the plate 320 or any other position of a plate in the electron-optical element 310, for example in the stack of plates of the electron-optical element 310. Alternatively or additionally, the charged particle device 41 may comprise a secondary column that comprises the detector or a portion of the detector.

In an embodiment, the plates of the charged particle optical device 310 are separated from each other by spacers 325. The spacers 325 may be electrically insulating to electrically isolate the plates from each other. In some embodiments, one or more of the spacers 325 may be provided with channels to allow gas to be pumped away from regions between the plates in a lateral direction. This may assist further with reducing the flow of gas from the down-beam volume 344 to the inner tube volume 340. One or more of the spacers may be in thermal contact with a cooling conduit for thermally conditioning the connected spacer and/or part of the stack around the spacer.

The embodiments of charged particle devices 41 having a beam tube 300 have been exemplified above in the context of the beam tube 300 and plate 320 being close to the sample, for example with the plate 320 being part of, connected to, or adjacent to, a control lens array or objective lens array. For example, in an arrangement of the type depicted in **FIG. 3****,** the plate 320 could be associated with the control lenses 250 or deflectors 235 for beam collimation and that are down-beam of the condenser lenses 231. Applying the approach to plates 320 near the sample 208 is particularly desirable because the amount of gas liberated (e.g., from outgassing and/or ESD) is particularly high in this region. However, the approach could also be applied to other plates in a charged particle apparatus 40. For example, in an arrangement of the type depicted in **FIG. 3****,** the approach could be applied to a plate forming part of or adjacent to the condenser lenses 231.

The charged particle device 41 may be provided as part of an assessment apparatus for assessing a sample using charged particles. The assessment apparatus may comprise a sample support configured to support the sample 208 and a detector configured to detect charged particles from the sample 208.

A charged particle device 41 according to an embodiment described above may be used in a method for assessing a sample 208 using charged particles. The method comprises using the charged particle device 41 to project one or more beams of charged particles towards the sample 208. The charged particle device 41 comprises the charged particle optical element 310. The charged particle optical element 310 directs the one or more beams towards the sample 208. The charged particle optical element 310 comprises the plate 320 in which is defined a plurality of beam apertures 311 and a plurality of vent apertures 312. The charged particle device comprises the beam tube 300 defining the inner tube volume 340 and the outer tube region 342. The one or more beam apertures 311 allow passage towards the sample of charged particles of the one or more beams (through the beam apertures), from the inner tube volume 340 to the down-beam volume 344 on the opposite side of the plate to the inner tube volume 340. The vent apertures 312 fluidically connect the down-beam volume 344 to the outer tube region 342. The method comprises pumping fluid from the down-beam volume 344 into the outer tube region 342 via the vent apertures 312.

In an embodiment, the method uses a pumping arrangement to pump down the inner tube volume 340 separately from the outer tube region 342. In an embodiment, the outer tube region 342 is pumped down using a pumping system that is separate from the pumping system used to pump down the inner tube volume. This enables the vacuum in the two volumes to be independently controlled. Embodiments of the disclosure seek to keep the volumes (and thus the vacuums) within the outer tube region 342 and the inner tube volume 340 separate from each other. One pump may be assigned to the inner tube volume 340; a different pump may be assigned to the outer tube region 342.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g., voltage supplies and/or current supplies) to control the component to manipulate the charged particle beam in this manner. For example, a voltage supply may be electrically connected to one or more components to apply potentials to the components, such as in a non-limited list including the control lens array 250 and the objective lens array 241.

References to upper and lower, up and down, above and below, etc. should be understood as referring to directions parallel to the (typically but not always vertical) up-beam and down-beam directions of charged particle beams impinging on the sample 208. Thus, references to up-beam and down-beam are intended to refer to directions in respect of the beam path independently of any present gravitational field.

Electron-optics described herein may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electromagnetic field of the compound lens array.

An assessment apparatus, tool or system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment apparatus, tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools).

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

Clause 1. A charged particle device for projecting one or more beams of charged particles towards a sample, the device comprising: a charged particle optical element configured to direct one or more beams of charged particles towards a sample, the charged particle optical element comprising a plate in which is defined one or more beam apertures and a plurality of vent apertures; and a beam tube defining an inner tube volume comprising paths up-beam of the plate of charged particles of the one or more beams, and an outer tube region that is outside of the beam tube, wherein: the one or more beam apertures are configured for passage towards the sample of charged particles of the one or more beams, from the inner tube volume to a down-beam volume on an opposite side of the plate to the inner tube volume; and the vent apertures are configured to fluidically connect the down-beam volume to the outer tube region.

Clause 2. The device of clause 1, wherein a total open area of the vent apertures is larger than a total open area of the one or more beam apertures.

Clause 3. The device of clause 1 or 2, wherein the vent apertures and the one or more beam apertures are configured such that a total flow conductance through the plate provided by the vent apertures is larger than a total flow conductance through the plate provided by the one or more beam apertures.

Clause 4. The device of any preceding clause, wherein the number of vent apertures is higher than the number of beam apertures.

Clause 5. The device of any preceding clause, wherein the one or more beam apertures and the plurality of vent apertures consist of apertures having a common dimension, common shape and/or common cross-sectional area.

Clause 6. The device of any preceding clause, wherein the one or more beam apertures comprises a plurality of beam apertures and an average separation between the beam apertures is equal to an average separation between the vent apertures; desirably the beam apertures are arranged in an aperture pattern having an aperture pitch, the vent apertures are arranged in a vent pattern having a vent pitch, and the aperture pitch and the vent pitch are equal; desirably the beam apertures and the vent apertures are arranged in respective two dimensional arrays having a common pattern.

Clause 7. The device of any preceding clause, wherein the beam tube comprises a facing surface spaced apart from the plate to define a flow passage, the flow passage being configured to restrict flow between the inner tube volume and the outer tube region.

Clause 8. The device of clause 7, wherein the beam tube comprises a flange portion and the facing surface is defined by the flange portion.

Clause 9. The device of clause 8, wherein the flange portion extends further from the paths of the charged particles than an adjacent portion of the beam tube, desirably the beam tube comprising a wall, the flange portion extending further from the paths of the charged particles than an outermost portion of the wall, desirably than an outermost portion of the wall adjacent to the flange portion.

Clause 10. The device of any of clauses 7 to 9, wherein a passage surface of the plate defining the flow passage is coplanar with a surface of the plate defining openings to the beam apertures, desirably the passage surface being on a plate side of the flow passage.

Clause 11. The device of any of clauses 7 to 9, wherein the plate comprises a protrusion and a surface defining the flow passage on a plate side of the flow passage is provided by the protrusion.

Clause 12. The device of any of clauses 1 to 6, wherein: the beam tube comprises a proximal part and a distal part, the proximal part being connected to the plate and the distal part being positioned on a distal side of the proximal part relative to the plate; and the proximal part and distal part comprise respective facing surfaces spaced apart from each other to define a flow passage, desirably the flow passage being configured to restrict flow between the inner tube volume and the outer tube region, desirably the proximal part and the distal part comprising respective flange portions that comprise the facing surfaces.

Clause 13. The device of any of clauses 7 to 12, wherein: a surface of the plate on an up-beam side of the plate has a central region, a peripheral region surrounding the central region, and a buffer region between the central region and the peripheral region and separating the central region from the peripheral region; the one or more beam apertures are defined in the central region; and the plurality of vent apertures are defined in the peripheral region.

Clause 14. The device of clause 13, wherein at least a portion of the facing surface of the beam tube faces the buffer region.

Clause 15. The device of clause 13 or 14, wherein the one or more beam apertures comprises a plurality of beam apertures and the plate defines a plurality of field distortion suppressing apertures configured to suppress distortions in the electrical field of peripheral beam apertures of the plurality of beam apertures.

Clause 16. The device of any of clauses 13 to 15, wherein the plate defines a plurality of blind holes opening into the down-beam volume, desirably wherein the field distortion suppressing apertures are the blind holes.

Clause 17. The device of clause 16, wherein at least a subset of the blind holes are positioned opposite to the buffer region.

Clause 18. The device of clause 16 or 17, wherein at least a subset of the blind holes are positioned opposite the facing surface of the beam tube on the other side of the plate from the beam tube.

Clause 19. The device of any of clauses 16 to 18, wherein the plurality of blind holes have a same dimension, shape and/or cross-sectional area as either or both of the one or more beam apertures and the plurality of vent apertures.

Clause 20. The device of any preceding clause, wherein the beam tube is metallic or comprises a metallic coating.

Clause 21. The device of any preceding clause, further comprising a detector configured to detect signal charged particles from the sample, desirably the detector being positioned between the plate and the sample, for example providing a facing surface of the device for facing the sample or desirably the device having a secondary column comprising the detector.

Clause 22. The device of any preceding clause, comprising at least one further plate down-beam of and coplanar with the plate, the or one of the further plates providing a facing surface of the device for facing the sample, wherein defined in one or more of the further plates are one or more beam apertures and a plurality of vent apertures, desirably wherein one or more of the vent apertures of the plate and of one or more of the further plates are aligned.

Clause 23. An assessment apparatus for assessing a sample using charged particles, the apparatus comprising: a sample support configured to support a sample; the charged particle device of any preceding clause configured to project one or more beams of charged particles towards the sample; and a detector configured to detect signal charged particles from the sample.

Clause 24. The apparatus clause 23, comprising a pumping arrangement configured to pump the inner tube volume separately of the outer tube region, desirably the pumping arrangement having separate pumps configured to pump the inner tube volume and the outer tube region.

Clause 25. A method of assessing a sample using charged particles, the method comprising: using a charged particle device to project one or more beams of charged particles towards a sample, wherein: the device comprises a charged particle optical element that directs the one or more beams towards the sample, the charged particle optical element comprising a plate in which is defined one or more beam apertures and a plurality of vent apertures; the device comprises a beam tube defining an inner tube volume comprising paths up-beam of the plate of charged particles of the one or more beams, and an outer tube region that is outside of the beam tube; the one or more beam apertures allow passage towards the sample of charged particles of the one or more beams, from the inner tube volume to a down-beam volume on an opposite side of the plate to the inner tube volume; the vent apertures are configured to fluidically connect the down-beam volume to the outer tube region; and the method comprises pumping fluid from the down-beam volume into the outer tube region via the vent apertures.

Clause 26. The method of clause 25, further comprising pumping down the inner tube volume separately from the outer tube region, desirably pumping down the outer tube region with one pump and the inner tube volume with a different pump.

## Claims

1. A charged particle device for projecting one or more beams of charged particles towards a sample, the device comprising:
a charged particle optical element configured to direct one or more beams of charged particles towards a sample, the charged particle optical element comprising a plate in which is defined one or more beam apertures and a plurality of vent apertures; and
a beam tube defining an inner tube volume comprising paths up-beam of the plate of charged particles of the one or more beams, and an outer tube region that is outside of the beam tube, wherein:
the one or more beam apertures are configured for passage towards the sample of charged particles of the one or more beams, from the inner tube volume to a down-beam volume on an opposite side of the plate to the inner tube volume; and
the vent apertures are configured to fluidically connect the down-beam volume to the outer tube region.

2. The device of claim 1, wherein a total open area of the vent apertures is larger than a total open area of the one or more beam apertures.

3. The device of claim 1 or 2, wherein the vent apertures and the one or more beam apertures are configured such that a total flow conductance through the plate provided by the vent apertures is larger than a total flow conductance through the plate provided by the one or more beam apertures.

4. The device of any preceding claim, wherein the number of vent apertures is higher than the number of beam apertures.

5. The device of any preceding claim, wherein the one or more beam apertures and the plurality of vent apertures consist of apertures having a common dimension, common shape and/or common cross-sectional area.

6. The device of any preceding claim, wherein the one or more beam apertures comprises a plurality of beam apertures and an average separation between the beam apertures is equal to an average separation between the vent apertures; desirably the beam apertures are arranged in an aperture pattern having an aperture pitch, the vent apertures are arranged in a vent pattern having a vent pitch, and the aperture pitch and the vent pitch are equal; desirably the beam apertures and the vent apertures are arranged in respective two dimensional arrays having a common pattern.

7. The device of any preceding claim, wherein the beam tube comprises a facing surface spaced apart from the plate to define a flow passage, the flow passage being configured to restrict flow between the inner tube volume and the outer tube region.

8. The device of claim 7, wherein the beam tube comprises a flange portion and the facing surface is defined by the flange portion.

9. The device of claim 8, wherein the flange portion extends further from the paths of the charged particles than an adjacent portion of the beam tube, desirably the beam tube comprising a wall, the flange portion extending further from the paths of the charged particles than an outermost portion of the wall, desirably than an outermost portion of the wall adjacent to the flange portion.

10. The device of any of claims 7 to 9, wherein a passage surface of the plate defining the flow passage is coplanar with a surface of the plate defining openings to the beam apertures, desirably the passage surface being on a plate side of the flow passage.

11. The device of any of claims 7 to 10, wherein:
a surface of the plate on an up-beam side of the plate has a central region, a peripheral region surrounding the central region, and a buffer region between the central region and the peripheral region and separating the central region from the peripheral region;
the one or more beam apertures are defined in the central region; and
the plurality of vent apertures are defined in the peripheral region.

12. The device of claim 11, wherein at least a portion of the facing surface of the beam tube faces the buffer region.

13. The device of claim 11 or 12, wherein the one or more beam apertures comprises a plurality of beam apertures and the plate defines a plurality of field distortion suppressing apertures configured to suppress distortions in the electrical field of peripheral beam apertures of the plurality of beam apertures.

14. The device of any of claims 11 to 13, wherein the plate defines a plurality of blind holes opening into the down-beam volume, desirably wherein the field distortion suppressing apertures are the blind holes.

15. The device of any preceding claim, wherein the beam tube is metallic or comprises a metallic coating.
